# EUROPEAN PATENT SPECIFICATION

(11) **EP 0 562 207 B1**
(45) Date of publication and mention of the grant of the patent: **05.06.1996**
(21) Application number: 92480048.5
(22) Date of filing: 27.03.1992
(51) Int. Cl.: H01L 21/82, H01L 27/11

(54) **Method of forming thin film pseudo-planar PFET devices and structures resulting therefrom**
Verfahren zum Herstellen von pseudo-planaren Dünnschicht PFET-Anordnungen und hierdurch erzeugte Struktur
Procédé pour former des dispositifs PFET à couche mince du type pseudo-planare et structure résultante

(43) Date of publication of application: 29.09.1993
(73) Proprietor: International Business Machines Corporation, Armonk, N.Y. 10504 (US)
(72) Inventor: Cederbaum, Carl, F-78000 Versailles (FR); Chanclou, Roland, F-77930 Perthes (FR); Combes, Myriam, F-91000 Evry (FR); Mone, Patrick, F-77310 Ponthierry (FR)
(74) Representative: Klein, Daniel Jacques Henri

(56) References cited:
- EP-A- 0 392 540
- EP-A- 0 475 688
- US-A- 4 240 097
- 1991 SYMPOSIUM ON VLSI TECHNOLOGY, DIGEST OF TECHNICAL PAPERS no. 4-1, 28 May 1991, OISO, pp. 23-24, XP000260003 ; K. TSUTSUMI et al.: "A High-Performance SRAM Memory Cell With LDD-TFT Loads"

## Description

The present invention relates to methods of manufacturing semiconductor devices and more specifically to a method of simultaneously forming thin film pseudo-planar polysilicon PFET devices and bulk FET devices in CMOS or BiCMOS semiconductor chips. The present invention also relates to the semiconductor structures resulting therefrom. In particular, the method has applicability in the forming of polysilicon PFETs that are extensively used as load devices in six device (6D) SRAM cells.

Until recently, polycrystalline silicon (polysilicon) resistors have been commonly used as load devices in Static Random Access Memories (SRAMs). Stacking polysilicon load resistors above the NFETs in so-called 4D/2R SRAM cells has been much appreciated in the design of the SRAM chip layout, because the cell area is then only determined by the room consumed by the NFETs, which in turn, results in a significant reduction in the SRAM cell size. The load resistors of such SRAM cells are formed by resistive polysilicon lands obtained from a very thin film or layer of either intrinsic or lightly doped polysilicon material. However, because these load resistors must be fairly high-valued, say in the tera-ohm (10E12) range or even above in order to decrease the current drawn by the cell, capacity of such SRAM cell chips appears to be limited to the 1-Mbit; beyond, the polysilicon layer should be so thin that the process tolerances would be too difficult to control. In addition, SRAM cells with load resistors are also very sensitive to soft errors produced by alpha particles and cosmic rays. Therefore, beyond this limit, resistively connected PFETs, instead of polysilicon resistors, have to be used as load devices although this is at the cost of a significantly more complicated manufacturing process.

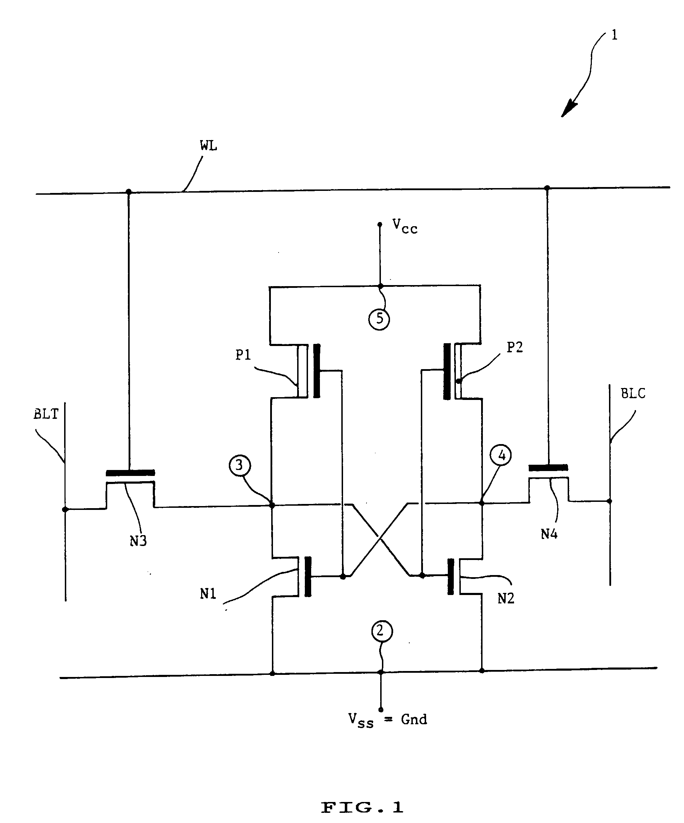

Fig. 1 shows a conventional 6D SRAM cell circuit referenced 1 with PFETs as load devices. Two cross-coupled NFETs N1 and N2, so-called the driver transistors, are connected between common node 2 tied to a first supply voltage Vss (usually the ground Gnd) and respective nodes 3 and 4, so-called charge storage nodes. These nodes 3 and 4 are connected to a common node 5 tied to a second supply voltage (usually a positive voltage Vcc), respectively through PFETs P1 and P2. On the other hand, nodes 3 and 4 are also respectively connected to the bit lines BLT and BLC through NFETs N3 and N4, so-called the access transistors. The gate electrodes of NFETs N3 and N4 are connected to the word line WL for READ and WRITE operations.

Because the complexity of said storage nodes 3 and 4, dense CMOS SRAM cells may be obtained in a great variety of manners. For instance, one may refer to an article entitled : "A 0.1 µA stand-by current ground-bounce-immune 1-M bit CMOS SRAM" by M. Ando et al, published in the IEEE JSSC vol. 24, N° 6, Dec. 89, pp. 1708-1713, which describes the use of stacked polysilicon gate PFETs (sPFETs) wherein NFET N1 and PFET P1 share the same gate electrode. This technique combined with a 0.8µm twin-well CMOS process resulted in a small memory cell size of 41µm² . The pros and cons of this approach are analyzed in EP-A-0 469 215 filed on 31 July 1990 and assigned to the present assignee.

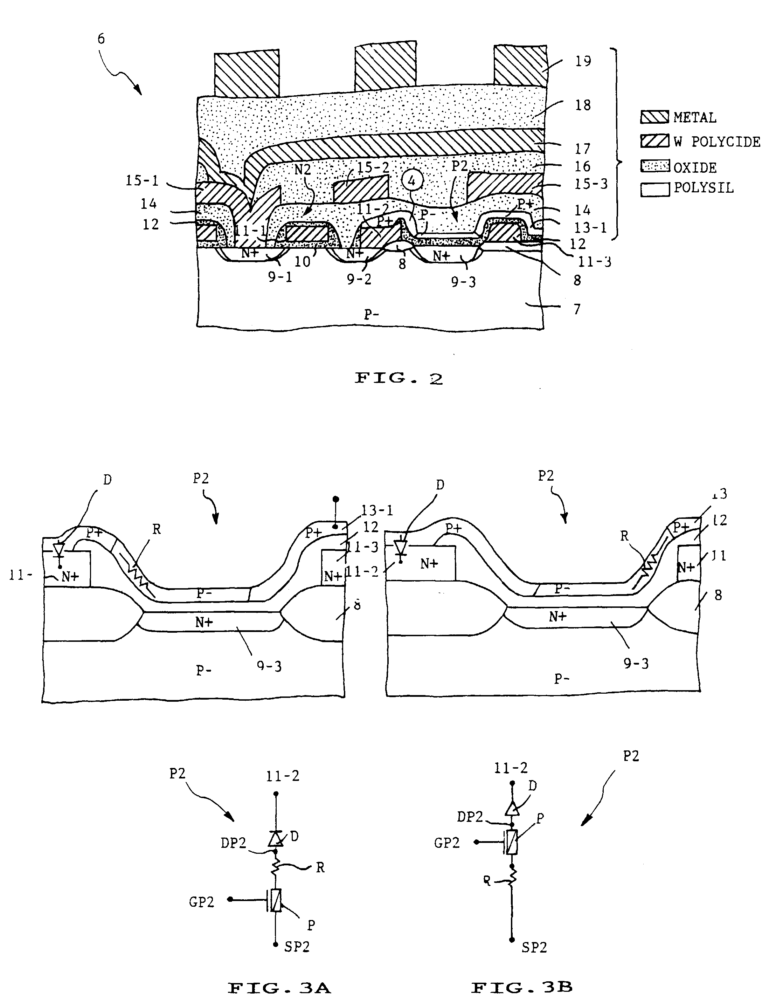

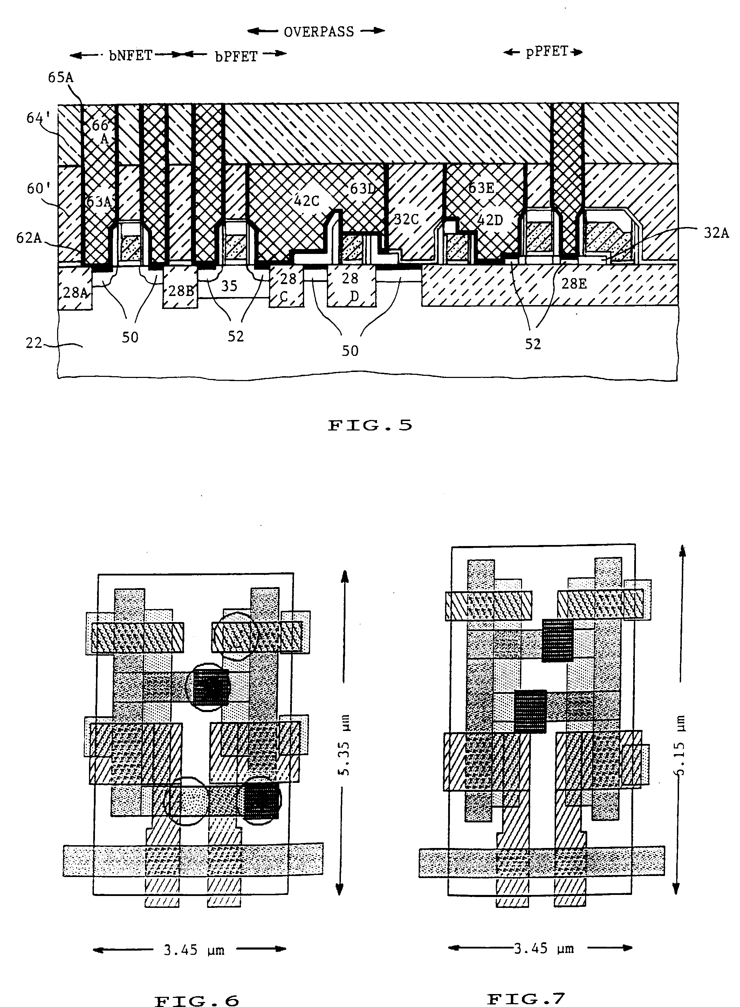

Another technique which takes advantage that NFET N1 and PFET P2 have their respective drain region and gate electrode at the same potential, is described in an article entitled: "TFT cell technology for 4M bit and more high density SRAMs" by M. Kinugawa et al, published in the IEEE 1990 symposium on VLSI Technology 4.3 pages 23-24. Fig. 2 of the present application which reproduces Fig. 7 of this article, shows a partial cross-sectional view of the structure of the 6D SRAM cell circuit of Fig. 1 when integrated in a semiconductor substrate according to the CMOS manufacturing process described therein. The PFETs used as load devices and fabricated using this thin-film manufacturing process will be referred to below as iPFETs because of their upside-down or inverted design. The structure referenced 6 is a good example of the most advanced state of the art known to date claiming a memory cell size of 20.3µm² for a 0.5µm CMOS process. In Fig. 2, reference numeral 7 indicates the P type silicon substrate. Numerals 8 indicate the different field recess oxide (ROX) regions that are used to isolate the different active regions of the structure. Numerals 9 are generically active N+ implanted source and drain regions of the NFETs, but some of these regions are also used as gate electrodes for the iPFETs. Fig. 2 is more particularly concerned by the FET devices N2 and P2 shown in Fig. 1. Numeral 10 indicates the gate dielectric layer, typically an SiO₂ layer, which forms the gate dielectric of the bulk FET devices, i.e. the NFETs and PFETs formed in the substrate as standard by the CMOS manufacturing process. The tungsten polycide layer 11 results from the alloying of highly doped N+ polysilicon with tungsten. Layer 11 is patterned to delineate the gate electrodes of the bulk FET devices. Gate electrodes of NFETs N2 and N1, respectively referenced 11-1 and 11-2 and numeral 11-3 designates the gate electrode of a non referenced FET device in Fig. 1. Gate electrode 11-2 forms a buried contact with region 9-2 which is the drain region DN2 of NFET N2. SiO₂ layer 12 forms the gate dielectric of the iPFETs and coats gate electrodes 11-1, 11-2 (partially) and 11-3. N+ doped region 9-3 plays both the role of gate electrode GP2 of iPFET P2 (oxide layer 12 is the gate dielectric thereof) and the drain region DN1 of NFET N1. A polysilicon land 13-1 coats gate electrodes 9-3 and 11-3 and is isolated therefrom by said SiO₂ layer 12. Polysilicon land 13-1 results from the patterning and selective doping of an lightly P doped polysilicon layer 13 (the doping is performed to adjust the voltage threshold VT of the iPFETs) that has been deposited and recrystallized to form the body of the iPFETs. As apparent from Fig. 2, this polysilicon land 13-1 is highly doped with a P type dopant except just above N+ region 9-3. The lightly doped portion of land 13-1 forms the channel region of the iPFET P2, while the adjacent highly P+ doped regions form the source and drain regions thereof respectively referred as SP2 and DP2. An extension of the drain region of iPFET P2 in polysilicon land 13-1, referred to below as the extended drain region EDP2, contacts the small portion of gate electrode 11-2 which is exposed through an opening in oxide layer 12. More generally, for each cell, oxide layer 12 is opened in all locations where it is necessary to make a contact between the N+ doped polysilicon gate electrode of a NFET and the adjacent P+ extended drain region of the corresponding iPFET. Note that N+ region 9-2, gate electrode 11-2 of NFET N1 and the extended drain region of iPFET P2 in land 13-1, are at the potential of node 4, achieving thereby the desired cross-coupling of the devices as illustrated in the cell circuit of Fig. 1. At this stage of the process, the structure is said to have completed the Master Slice processing steps of a polysilicon gate CMOS FET technology, i.e. the bulk and thin-film FET devices have been fabricated in the substrate. The structure is passivated by a relatively thick insulating SiO₂ layer 14 of about 500nm. As such, the structure results from the FEOL (Front End Of the Line) processing. Elements that will now be described are formed during the personalization steps or BEOL (Back End Of the Line) processing. Tungsten polycide lands 15-1, 15-2 and 15-3 result from the patterning of a tungsten polycide layer 15. In Fig. 2, polycide land 15-1, which connects a N+ active region 9-1 (the source region of NFET N2) to the ground, will be referred to thereafter as the Gnd bus. An additional insulating SiO₂ layer 16 terminates the structure. Insulating layer 16 is provided with contact openings to allow appropriate contacting with the metal bit lines BLT and BLC and power busses (e.g. the Vcc power bus) that are obtained after the patterning of an aluminum-silicium (Al-Si) layer 17. The whole structure is passivated by SiO ₂ layer 18. An additional second aluminum layer 19 is shown on the top of the structure. All the succeeding layers, and in particular polysilicon layer 13, are conformally deposited. Consequently, the upper layers of structure 6 have in reality a typical "corrugated" or "castellated" relief aspect.

The cell construction of Fig. 2 wherein the iPFETs are used as load devices is of great interest in terms of density, because the cell area is substantially determined by the area of the bulk NFETs. However, the disclosed semiconductor structure and its corresponding manufacturing process have some major inconveniences that are recited below which result in significant potential problems.
1. To manufacture the structure of Fig. 2, requires six more additional masks with respect to a conventional manufacturing process of 6D SRAM cell chips not offering iPFETs in the menu. The first mask is used to partially remove the gate oxide layer 10 above source region 9-2 of NFET N2 to allow the buried contact between gate electrode 11-2 and said region 9-2. The second mask makes an opening in layer 12 above gate electrode 11-2. The third mask is used to pattern the P type lightly doped polysilicon layer 13, to shape the desired polysilicon land 13-1 wherein the body of iPFET P2 and its related extended drain region (for connection with underlying gate electrode 11-2) are to be formed. The fourth mask is a block-out mask that is required to protect the channel region of iPFET P2 body from the implantation of P type dopants to form the highly doped P+ source and drain regions thereof. The said extended drain region is formed at this stage of the process. The fifth mask defines contact openings in layer 14 where polycide lands, e.g. 15-1, conveying the Gnd potential, contact source regions 9 of certain NFETs, e.g. source region SN2 of NFET N2 in Fig. 2. Finally, the sixth mask delineates said polycide lands e.g. 15-1, the word lines and some power busses.
2. Because region 9-3 is the drain region DN1 of NFET N1 and also the gate electrode GP2 of iPFET P2, the layouts of these two devices are strongly interdependent both in terms of device size and device lay-out, which in turn, results in less flexibility in their respective design. More generally, since the width of diffusion regions 9-1, ... of the driver NFETs, e.g. N1, must be at the minimum allowed by the technology for a maximum density, the gate length of the iPFETs, e.g. P2, is thus determined. This constitutes a potential source of reliability hazards. In particular, if the out-diffusion of the P+ dopants contained in the implanted source and drain regions of iPFET P2 is not well controlled, the source and drain regions SP2 and DP2 get too large, thereby reducing the effective channel length of iPFET P2. As a consequence, punch-through problems can occur. The channel length of iPFET P2 cannot be increased (if maximum density is sought) since this length is dictated by the performance requirements of NFET N1.
3. The structure of iPFET P2 illustrated in Fig. 2 is upside-down, thus self-alignment registration (SAR) is not possible. Because, the block-out mask defining the channel region of iPFET P2 is at the minimum image size, alignment tolerance between this block-out mask and the channel region can result in a channel region not correctly aligned with the gate electrode. Figs. 3A and 3B are enlarged views of the portion of structure 6 which more particularly shows iPFET P2, to illustrate the effect of such a misalignment on the electrical characteristics thereof. This effect mainly consists in the introduction of a parasitic resistor to an ideal PFET P that would have been obtained, should misregistration not exist, as it will be now explained. Note that such PFET P has already inherently a poor performance. In both cases (positive and negative misalignment) shown in the upper part of Figs. 3A and 3B, a high value resistor R is in series with the drain or source region of the said ideal PFET P as illustrated in the lower part of Figs. 3A and 3B, which show the equivalent electrical schematic. This parasitic resistor decreases the effective gate to source overdrive voltage (VGS-VT) of iPFET P2 (which has already a high threshold voltage VT) and hence will decrease its "ON" current. Finally, in any case of misalignment, iPFET P2 is far from an ideal PFET P. In addition, due to their upside-down construction, iPFETs can't be provided with improved source/drain structures such as LDD (Lightly Doped Drain). This can be a problem, because the effective length of the iPFETs is very sensitive to the source/drain dopant out-diffusion as mentioned above, which is admittedly difficult to maintain low in polysilicon.
4. Since the iPFETs are formed after the bulk devices have been completed, the thermal budget necessary to polysilicon recrystallization and source/drain dopants reactivation has to be maintained low to minimize the impact of these steps on the bulk FET devices and on the underlying tungsten polycide layer forming the gate electrodes 11-1,... This is a further limitation for improving the iPFET performances.
5. The gate electrode of the iPFET P2 has not an optimized work function. Since the iPFET P2 gate electrode is formed by the N+ drain region of a driver transistor, e.g NFET N1, there is no flexibility for selecting the type of conductivity of the said gate electrode. The gate electrode of the iPFET is therefore of the N+ type while P+ type would have been preferred. It is well recognized that this situation creates some problems from the punch-through point of view. In particular, punch-through effects induce leakage currents which are critical for the SRAM cell stand-by power consumption.
6. As pointed out above in conjunction with Fig. 2, the conventional manufacturing process results in a non planarized structure 6. The gate oxide layer 12 and the polysilicon layer 13 forming iPFET P2 are deposited over the castellated topology of the gate electrodes 11-1, 11-2, 11-3,... although slightly smoothed by SiO₂ layer 12. A non planar topology causes reliability prublems, known under the brand name of "step coverage", since polysilicon layer 13 is much thinner than the polysilicon layer 11 forming the gate electrodes.
7. A parasitic P+/N+ diode referenced D in Figs. 3A and 3B is formed between N+ gate electrode 11-2 of NFET N1 and the P+ extended drain region of iPFET P2. This diode deteriorates the contact quality which is no longer of the ohmic type thereby slowing down the SRAM cell overall performance.
8. The power busses and possibly the local interconnect scheme that makes straps and short distance connections at the silicon wafer level, are made of polycide. Tungsten polycide is a good conductive material, notwithstanding all, it is known to exhibit higher resistivities than metals.

The above cited problems are favorably solved by the manufacturing method of the present invention and the integrated circuit structures resulting therefrom.

The manufacturing method used to produce the said semiconductor structures include the following sequence of steps:
a) elaborating a P type silicon substrate having a major surface provided with a plurality of isolation regions as the initial structure;
b) delineating polysilicon lands above certain isolation regions;
c) forming N-well regions into the substrate where bulk PFETs are to be subsequently formed;
d) forming insulator encapsulated conductive polysilicon studs to be used in particular as gate electrodes at desired locations of the structure;
e) forming self-aligned source/drain regions of the bulk NFETs into the substrate;
f) forming self-aligned source/drain regions of the bulk PFETs and pPFETs into the substrate and polysilicon lands respectively;
g) forming contact regions to the desired locations including said source/drain regions; and
h) exposing the top of certain polysilicon studs;
i) blanket depositing an etch stop layer onto the structure;
j) forming an insulating matrix provided with openings onto the structure exposing desired locations of the underlying etch stop layer;
k) etching said exposed regions of the etch stop layer; and,
l) filling the openings of said matrix with a conductive material to form contact studs;

In another alternate embodiment the method includes prior to step h) the step of:
m) forming an etch stop layer over certain polysilicon studs and certain regions of the substrate to facilitate the subsequent formation of overpass conductors.

It is therefore a primary object of the present invention to provide a method of forming thin film pseudo-planar polysilicon gate PFETs as load devices in 6D SRAM cells that implies a reduced number of additional masking steps with respect to a standard CMOS manufacturing process.

It is another object of the present invention to provide a method of forming thin film pseudo-planar polysilicon gate PFETs as load devices in 6D SRAM cells that is independent of NFET device size and lay out, avoiding therefore potential punch-through problems.

It is another object of the present invention to provide a method of forming thin film pseudo-planar polysilicon gate PFET devices in 6D SRAM cells that include LDD and SAR features eliminating thereby problems resulting from misregistration.

It is another further object of the present invention to provide a method of forming thin film pseudo-planar polysilicon gate PFETs as load devices in 6D SRAM cells that has no thermal budget constraints.

It is another object of the present invention to provide a method of forming thin film pseudo-planar polysilicon gate PFETs as load devices in 6D SRAM cells wherein the gate electrodes of said devices are made of P+ polysilicon for an adequate work function.

It is still another object of the present invention to provide a method of forming thin film pseudo-planar polysilicon gate PFETs as load devices for 6D SRAM cells wherein said PFETs are formed on planar isolating surfaces for better reliability.

It is a further object of the present invention to provide a method of forming thin film pseudo-planar polysilicon gate PFETs as load devices in 6D SRAM cells wherein no parasitic diodes are produced in the contacts for better performance.

It is still another further object of the present invention to provide a method of forming thin film pseudo-planar polysilicon gate PFETs as load devices in 6D SRAM cells wherein word lines, power busses and local interconnect straps are formed of metal for improved conductivity.

Compared to the prior art approach described in conjunction with the structure of Fig.2, the method of forming thin film pseudo-planar polysilicon PFET (pPFET) devices for 6D SRAM cells and the structures resulting therefrom of the present invention have definite advantages that are recited below.
1. Only three or four extra masks are required; in the latter case, the method allows implementation of useful overpass conductors.
2. The pPFET size and lay-out are independent of the underlying bulk NFET size and lay-out.
3. The pPFET can take benefit of all the engineering done for the bulk FET devices, e.g. the source/drain are self-aligned with the gate electrode and LDD structures can be obtained. Finally, a short channel length is achievable in spite of the fast out-diffusion of dopants in polysilicon.
4. There is no constraint on the thermal budget associated to the pPFET, because the polysilicon layer forming the "body" thereof is deposited and recrystallized prior to any process steps necessary to fabricate the bulk FET devices. On the other hand, the source/drain dopants reactivation of the pFETs is simultaneously performed with the bulk FET devices.
5. The pPFET is controlled by a tungsten polycide gate electrode for optimized work function.
6. The pPFET is formed onto a planarized surface.
7. The N+/P+ diode contact structure is replaced by a tungsten contact stud which provides an excellent ohmic contact.
8. Word lines WL, Gnd and Vcc power busses, and the local interconnect conductors are made of metal instead of tungsten polycide.

The features of this invention are set forth in the appended claims. The invention, as well as other objects and advantages thereof, may best be understood by reference to the following detailed description of an illustrated preferred embodiment to be read in conjunction with the accompanying drawings.

In the drawings:

Fig. 1 is a diagram showing a conventional 6D SRAM cell circuit including two PFETs as load devices.

Fig. 2 is a cross-sectional view partially broken away of the structure of the 6D SRAM cell circuit of Fig. 1 when integrated in a silicon substrate according to a conventional CMOS FET manufacturing process offering thin-film inverted polysilicon gate PFET devices (iPFETs).

Figs. 3A and 3B shows an enlarged view of the iPFET device structure of Fig. 2 that illustrate the parasitic resistor introduced therein depending positive or negative mask misregistration.

Figs. 4A to 4Z illustrate a preferred embodiment of the method of the present invention through a sequence of processing steps.

Fig. 5 shows an enlarged view of the structure which finally results of the method of the present invention when overpass conductors are included therein.

Fig. 6 is a plan view showing a typical lay-out of a 6D SRAM cell that results from the above processing steps described in Figs. 4A to 4Z where overpass conductors are formed.

Fig. 7 is a plan view showing another typical layout of a 6D SRAM cell that results from an alternate method according to which no overpass conductors are formed.

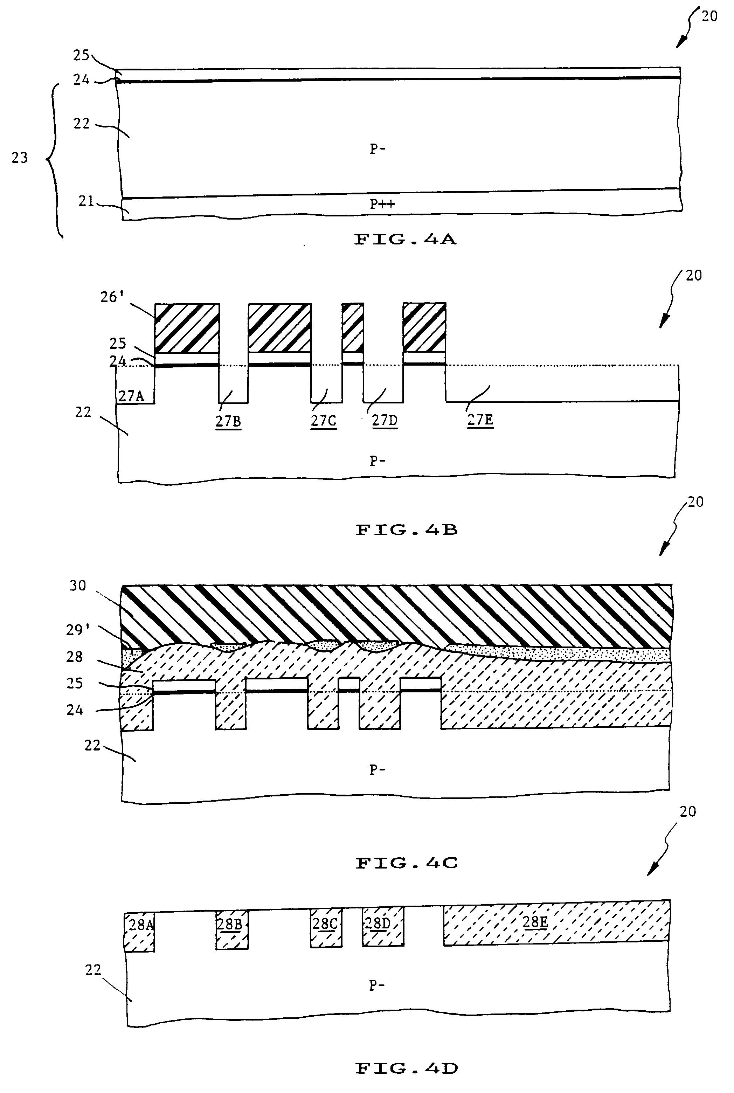

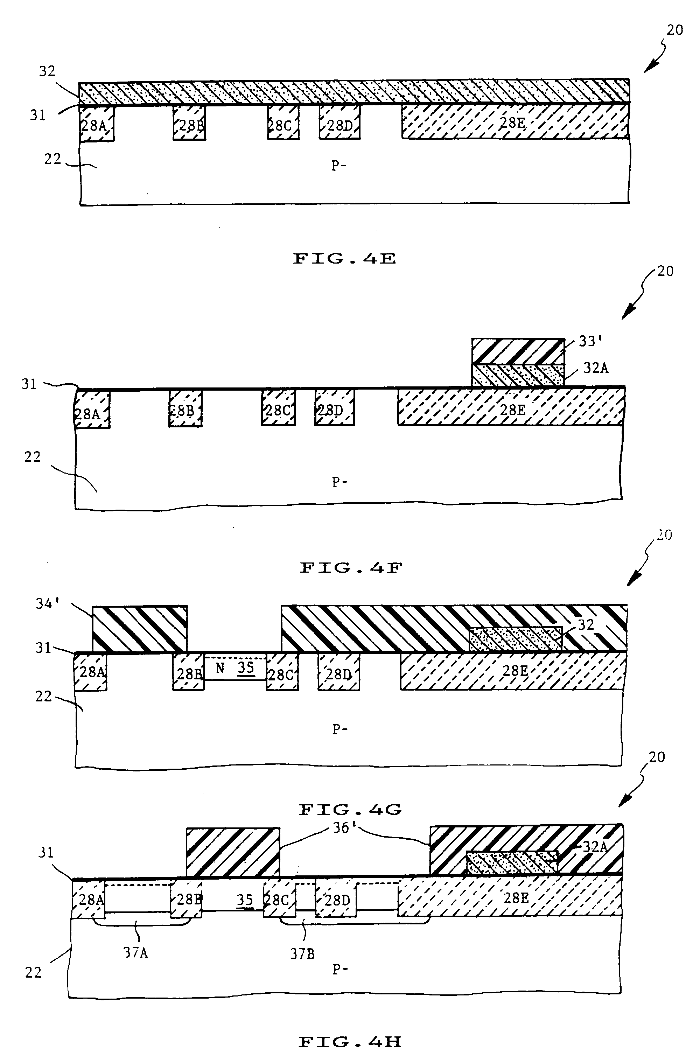

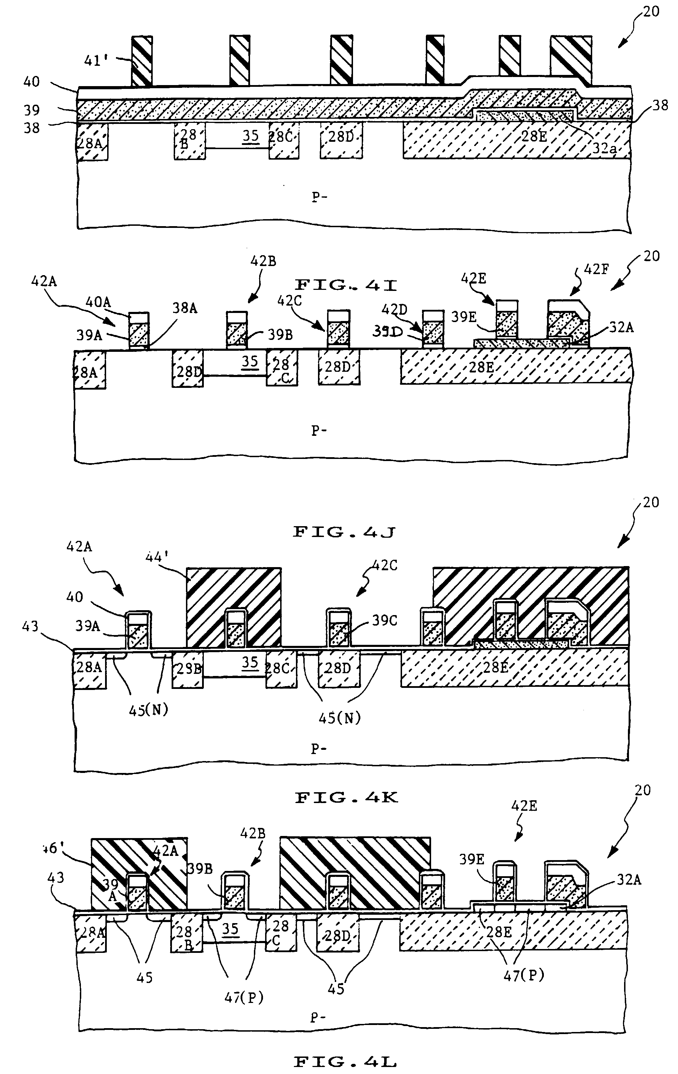

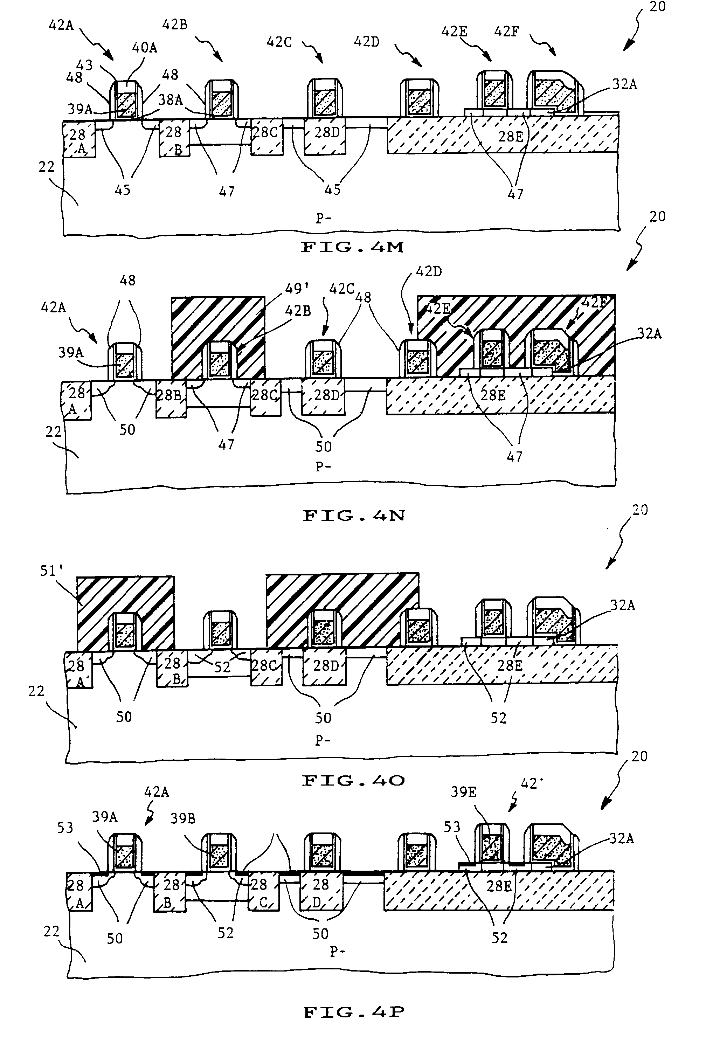

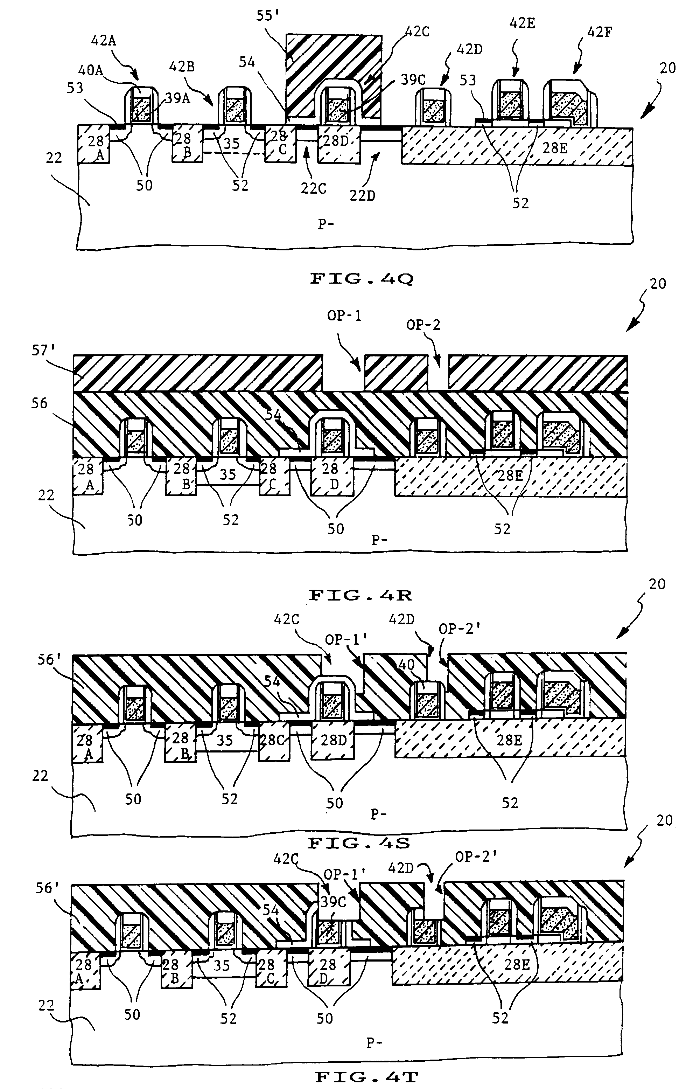

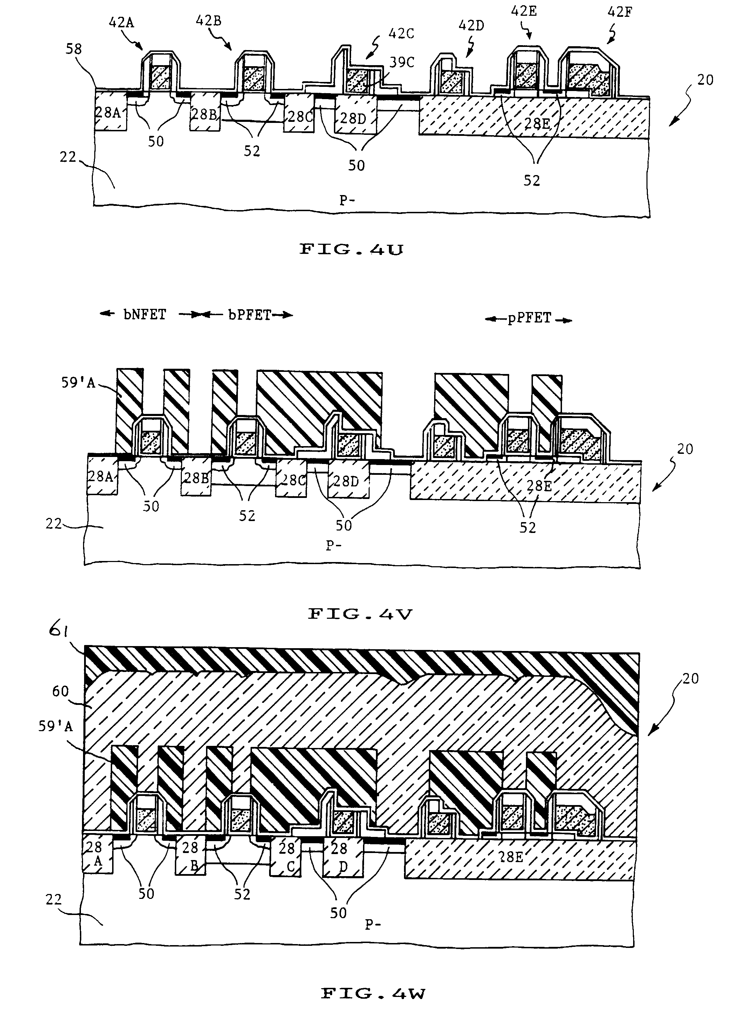

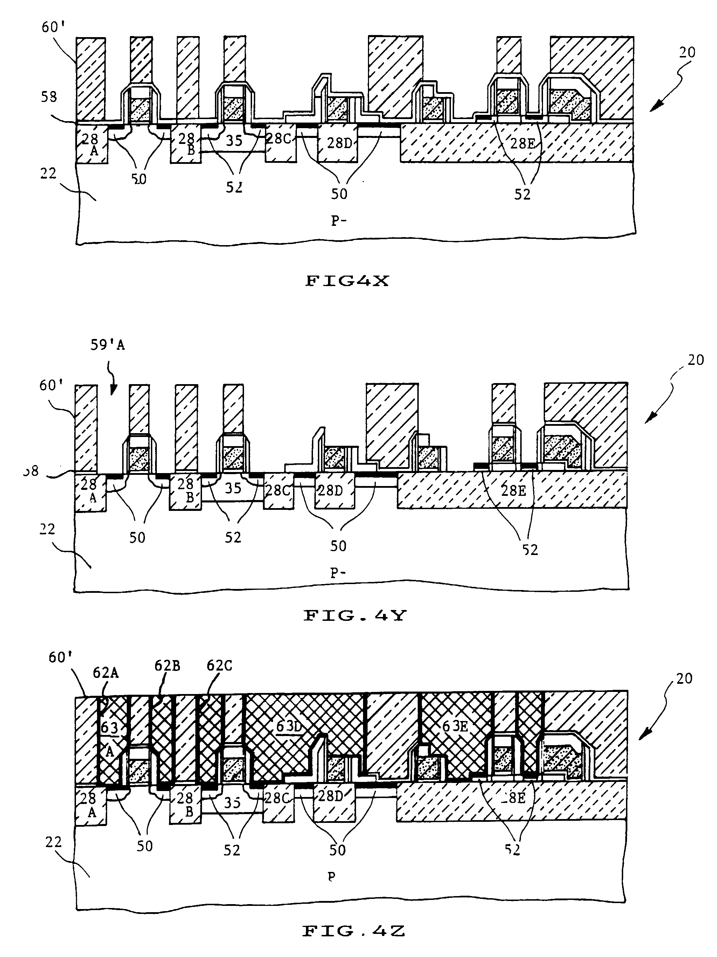

A preferred embodiment of the method of the present invention will be described with reference to Figs. 4A to 4Z which illustrate a silicon wafer undergoing the various processing steps of a CMOS process that fabricates bulk PFETs and NFETs along with said pFETs as load devices for 6D SRAM cells.
1. Now turning to Fig. 4A, there is illustrated the structure referenced 20 at the initial stage of the manufacturing process. A P⁺⁺ body 21 having a 2µm thick P⁻ epitaxial layer 22 deposited thereon forms the starting substrate 23. The major surface of this substrate is coated with a bottom 14.5 nm thick SiO2 pad layer 24 and a top 160nm thick Si3N4 pad layer 25.
2. A 1.3 µm thick photoresist layer 26 is applied onto the initial structure 20 of Fig. 4A, then exposed and developed as standard to provide the desired masking pattern 26'. The exposed areas of the composite Si3N4/SiO2 pad inverser oxide layer 24/25 and the underlying epitaxial layer 22 are then etched in an AME 5000 equipment using a NF3/N2/He gas composition. As a result, approximately 600nm deep, shallow isolation trenches, generically referenced 27, are formed in the epitaxial layer 22. Both narrow (e.g. 27B) and large (e.g. 27E) trenches are defined. The resulting structure is shown in Fig. 4B.
3. The remaining photoresist mask 26' is stripped off by ashing in the same AME 5000 equipment in an O2 atmosphere. The wafer is then cleaned in a SO4H2/H202 solution. Trenches 27 are now filled with oxide for isolation purposes. To that end, a very thin (e.g. 45nm) thermal oxide layer (not shown) is first grown in the trenches. Next, the trenches are filled with TEOS (Tetra Ethyl Ortho Silicate) oxide by depositing a blanket 850 nm thick TEOS layer 28 by LPCVD in a SVG equipment over the entire wafer surface. As apparent from Fig. 4C, layer 28 is deposited conformally i.e. it fills up the trenches 27, but, in despite TEOS layer 28 is thicker than the trench deepness, the TEOS coating exhibits a non planar surface with protuberances or hillocks between the trenches. As a result, the wafer surface needs to be planarized. Should a good planarizing medium, e.g. a photoresist which has the same etch rate ratio that TEOS and adequate viscosity, a standard etch-back process such as described in US-A- 4541168 could be used. But, preferably, the following step which aims to perfectly compensate for the surface irregularities can be employed. Still referring to Fig. 4C, a 0.760µm thick photoresist layer 29 is applied onto the structure, then exposed, developed and baked at 190°C. Appropriate photoresists that can be used in the present method include Merck EM3100 and the like. The mask 29' that is produced is used not to delineate the underlying layer as usual, but just to coarsely fill the cavities above the trenches. Next, the above mentioned planarizing medium is applied onto the structure to form layer 30 with a thickness of 0.830µm then, baked at 130°C. The structure at this stage of the process is shown in Fig. 4C. More details concerning this planarization technique can be found in Solid State Technology, Jan. 1991 pp 53-56 in the article: "Planarized inorganic interlevel dielectric for multilevel planarization by A. Noggy et al.
4. The structure is now submitted to RIE etch-back in an AME-5000 equipment using a NF3/CHF3/CO2 mixture in order to remove said protuberances in the TEOS layer 28. Because there is no etch-stop layer, the etch-back step is carefully monitored to stop just slightly above the pad nitride layer 25. Then, to reach the mirror-quality of the structure top surface, the structure 20 is chem-mech polished. The TEOS oxide layer 28 is polished down to the nitride layer 25 (which acts as the etch stop layer) in a chem-mech Westech polisher. As a result, the damages due to the previous RIE etching are removed. The wafer is then annealed at 1000°C in an argon atmosphere to densify the oxide fill. Next, the pad oxide composite layer 24/25 is removed. The Si3N4 pad layer 25 is first eliminated in H3PO4 at 165°C and then the SiO2 pad layer 24 is stripped off by dipping in diluted HF (10:1). The final structure is shown in Fig. 4D, where the isolation regions or islands formed by the densified TEOS oxide fills in the trenches 27 are generically referenced 28.
5. As apparent from Fig. 4E, the process continues with the formation of a sacrificial SiO2 layer 31 that is grown at 800°C and with a thickness of 22.5nm, followed by the deposition of a 100nm thick polycristalline silicon layer 32, for instance, by LPCVD at 560°C in a SVG equipment or in a CVD ASM EPSILON equipment. Alternatively, TEOS may be used instead of SiO2 to form layer 31 to increase silicon nucleation site density. The polysilicon layer 32 is amorphized by implanting silicon ions therein (not required if amorphous silicon is deposited). The amorphized polysilicon material of layer 32 may be recrystallized at this stage, but preferably is performed later on. This step is completed at 600°C, during 10 H, to reach a 3-5µm grain size.
6. The polysilicon layer 32 is now patterned to delineate the polysilicon lands that are subsequently required to define the body of the pPFETs of the present invention. To that end, a photoresist layer 33 (0.6 µm thick) is applied onto the structure, appropriately exposed, and developed to form an in situ mask 33'. The exposed areas of the polysilicon layer 32 are etched in an AME-5000 equipment using a Cl2/HCl gas mixture. The structure 20 with one polysilicon land referenced 32A formed above large oxide island 28E is illustrated in Fig. 4F. Next, the photoresist mask 33' is removed. The wafer is then cleaned in a sulfuric/peroxide solution. Preferably, the recrystallization step just mentioned above is completed now. Because of the limited size of lands 32A, ... at this stage of the process , during the recrystallization step, said polysilicon lands may even become monocrystalline, i.e., in each land, e.g. land 32A, the polysilicon material recrystallizes to form a single grain. This results in a pPFET having acceptable performance. Finally, the voltage threshold of the pPFETs is adjusted by a blanket ion implantation of phosphorous dopants in the polysilicon lands. It is important to notice, that unlike the conventional process disclosed in Ref. 2, recrystallization of polysilicon material is completed at a stage (i.e. at step 5 or 6) where the bulk FET devices have not been formed yet. However, for the reasons given above, it is recommended to have said recrystallization step completed in the present step.
7. Referring to Fig. 4G, a new 2µm thick photoresist layer 34 is deposited onto the structure, exposed and developed as standard. The mask referenced 34' aims to define the N-wells. A two-step ion implantation is now conducted to introduce phosphorous P+ dopants in the exposed portions of the epitaxial layer 22 to convert the surface regions thereof in N type regions to be used as N-wells for bulk PFETs as known to those skilled in the art. For example, P+ ions are first implanted at a dose of 3E13 at/cm² and an energy of 850 KeV, next at a dose of 2E12 at/cm² and an energy of 195 KeV. At this stage of the process, the voltage threshold VT of the bulk PFETs is adjusted by implanting BF2+ ions in the N-well regions, at a dose of 3E12 at/cm² and an energy of 50 KeV. As apparent from Fig. 4G, the structure 20 is now provided with a N-well region 35, the shallow region formed therein by the BF2+ implantation, is delimited by the dotted line.
8. The masking layer 34' is removed by ashing in O2 in a BRANSON 3300 tool, and the wafer is cleaned. A new 1.1µm thick photoresist layer 36 is applied onto the structure, exposed and developed as standard to define in-situ mask 36'. Likewise, boron ions B+ are then implanted in two steps. The first shallow implantation step (dose: 1.6E12 at/cm² , energy: 90KeV) aims to limit punch-through damages at the surface (see the dotted line near the wafer surface in Fig. 4H) and the second deep implantation (dose: 2E12 at/cm², energy: 195 KeV) creates the field regions 37A,... that, in particular, prevent undesired shorts between N⁺ regions formed into the epitaxial layer 22, where NFETs are to be subsequently formed. The resulting structure is shown in Fig. 4H. For sake of simplicity, field regions 37A, ... will no longer be represented in the following drawings.
9. Next, the resist mask 36' is removed by ashing and the wafer is cleaned as mentioned above. Then, the wafer is dipped in diluted HF (10:1) to strip off the sacrificial SiO2 layer 31 everywhere except under polysilicon land 32A. This remaining portion of Si02 layer 31 which lies above TEOS oxide filled island 28E and beneath polysilicon land 32A will no longer be represented in the drawings. The wafer is now thermally oxidized at 800°C, so that a 10nm thick Si02 insulating layer 38 is grown over the structure. It will be subsequently used as the gate dielectric of the bulk FET and pPFET devices. The process continues with the deposition of a base 2300nm thick intrinsic polysilicon layer by LPCVD. Then, a tungsten silicide (WSix) layer with a thickness of about 250nm is formed thereupon in a GENUS CVD equipment. This composite layer is referenced 39 in Fig. 4I. Instead of WSix, a 250nm thick titanium disilicide (TiSi2) may be deposited in a VARIAN sputter equipment. Optionally, a top polysilicon layer (not represented) could be blanket deposited onto the structure in a LPCVD equipment to reach a thickness of about 30nm. Phosphorous ions are now implanted in layer 39 in a AME PI 9200 equipment. This step aims to make conductive the polysilicon material of layer 39 that will subsequently form the conductors and the gate electrodes of bulk FET and pFET devices. A 400nm thick cap TEOS layer 40 is then deposited by LPCVD onto the structure in an AME 5000 equipment. The structure is annealed at 950°C (800°C for the TiSi2 option). Finally, a 1.1 µm thick photoresist layer 41 is applied, exposed and developed as standard to leave mask 41'. The resulting structure is shown in Fig. 4I.
10. Using mask 41', the structure is submitted to RIE etching in an AME 5000 equipment is a CHF3/Cl2/02 atmosphere to remove the exposed zones of the cap TEOS layer 40 and the composite polysilicon/WSix underlying layer 39. SiO2 layer 38 acts as the etch-stop layer for this step. The wafer is cleaned first in diluted HF (10:1), which by the way eliminates the exposed portions of layer 38, then in a sulfuric acid/peroxide solution. As apparent from FIG. 4J, a plurality of lines generically referenced 42 remain onto the structure at this stage of the process. For example, line 42A comprises a bottom oxide pad 38A, a polysilicon plug 39A, and a top TEOS capping 40A. These oxide sandwiched polysilicon plugs 39A, ... will subsequently form the gate electrodes of bulk FET and pPFET devices and conductors as well.
11. In the next step, the N-LDD regions for bulk NFETs are constructed. First, oxide sidewalls are formed on the remaining polysilicon/WSix lines 39A, .... To that end, a 34nm thick TEOS layer 43 is blanket deposited onto the structure. Next, the structure is oxidized at 900°C (800°C for the TiSi2 option) to increase the thickness of the oxide coating the sidewalls of the said lines. This thermal step also results in the anneal of the polysilicon plugs. Next, a 1µm thick photoresist layer 44 is patterned as standard to leave mask 44', as illustrated by Fig. 4K. A dual ion implantation step is conducted, first with arsenic As+ ions (90 KeV, 2E14 at/cm2), then with phosphorous P+ ions (45Kev, 3E13 at/cm2), to create the N-LDD regions referenced 45 in Fig. 4K.
12. Now, the P-LDD regions are formed. Similarly, a new photoresist layer 46 is patterned to provide mask 46' and P-LDD regions 47 are created in both bulk PFET and pPFET devices by implanting boron ions B+ (12 keV, 1.4E14). At this stage of the process the structure is shown in Fig. 4L (the hatchings in land 32a have been removed for sake of illustration). Mask 46' is eliminated by ashing and the wafer cleaned just as said above.
13. A 200 nm thick TEOS layer 48 is conformally deposited onto the structure 20, then RIE etched anisotropically in an AME-5000 equipment to leave 130nm thick vertical portions or spacers 48 on the SiO2 sidewalls previously formed (at step 11). The structure is annealed at 900°C (RTA for TiSi2). The resulting structure is shown in Fig. 4M, where it is apparent that polysilicon plugs look like being oxide encapsulated. For instance, polysilicon plug 39A is isolated from the major wafer surface by the thin dielectric layer 38A. TEOS pad 40A ensures capping, while the remaining portion of dual oxide layer 43/48 ensures lateral coating.
14. N⁺ source and drain regions of bulk NFETs are now formed. A 1µm thick photoresist layer 49 is applied onto the structure, exposed and developed to provide mask 49' (mask 49' is identical to mask 44'). Arsenic ions As+ are then implanted (dose: 2E15 at/cm²; energy: 80 KeV) to form the N⁺ source and drain regions 50 (including the N-LDD regions formed previously) of the bulk NFETs as illustrated, in particular in Fig. 4N, on both sides of line 42A.
15. In a very similar manner, as illustrated in Fig. 40, after formation of resist mask 51', P⁺source and drain regions 52 (including the P-LDD regions formed previously) of bulk PFETs and pPFETs are formed. The present step is terminated by a rapid activation anneal (RTA) of the structure completed at 800°C.
16. The wafer is cleaned and titanium (Ti) is sputter deposited in a VARIAN equipment to form a blanket 40 nm thick Ti layer 53. The structure is then sintered by rapid thermal processing (RTP) at 675°C which causes TiSi2 formation at Ti/Si interface. Next, the titanium that has not reacted is removed by dipping the wafer in a Huang A solution. The TiSi2 regions that have been formed during this step are still referenced 53 in Fig. 4P. The process continues with the preferred steps of forming the metallization.
17. Now turning to Fig. 4Q, a 100nm thick TEOS layer 54 is blanket deposited onto the structure. Next, a 0.6µm thick photoresist layer 55 is applied onto the structure, exposed and developed as standard to form mask 55'. The structure is then submitted to RIE etching in an AME 5000 equipment using a CHF3/O2 gas mixture. As a result, the exposed areas of TEOS layer 54 are etched. This layer 54 is useful above some regions of the epitaxial layer 22, e.g. in region 22C, to define the overpass conductors that will be subsequently formed. As illustrated in Fig. 4Q, mask 55' only partially covers region 22D, but it could have fully covered it as well. In the present instance, the overpass conductor will connect the gate electrode consisting of plug 39C in line 42C with a source/drain region 52 of the bulk PFET formed in N-well 35, as explicited later on. Finally, mask 55' is stripped by ashing in O2 and the wafer cleaned as standard. Note that, should no overpass conductors be required, masking step 17 would not be necessary.
18. A multilayer resist mask to define contacts to polysilicon gate electrodes is now formed. A first 1µm thick photoresist layer 56 is formed onto the structure of Fig. 4Q, then baked at 200°C for hardening. This step inhibits photoactive capabilities of layer 56. A second 0.6µm thick photoresist layer 57 is then deposited thereupon. The top photoresist layer 57 is exposed and developed as standard to form mask 57'. The structure that is thus obtained is shown in Fig. 4R, with two openings referenced OP-1 and OP-2 that will illustrate the way of contacting oxide capped polysilicon gate electrodes in lines 42C and 42D, to be used in the overpass conductor structure mentioned above and as a standard gate electrode contact respectively.
19. Now, the pattern of mask 57' is transferred to the underlying bottom layer 56. The structure is etched in an AME 5000 tool using O2. This step fully consumes photoresist mask 57' and results in openings OP-1', ... The remaining portion of the TEOS oxide layer 54 acts as the etch stop layer in the openings of layer mask 56'. Etch end point is detected by standard emission spectroscopy. The resulting structure at this stage of the process is shown in Fig. 4S.
20. Next, the RIE process is continued for over-etching. Turning to Fig. 4T, exposed oxide regions above lines 42C and 42D, are etched using layer 56' as a mask in an AME 5000 tool with a CHF3/O2 atmosphere. Using still standard emission spectroscopy, the top WSix capping of the composite polysilicon/WSix layer 39 is used as the etch-stop layer for that step.
21. Mask 56' is now removed by ashing in O2 and the wafer is cleaned. A thin (e.g. 50nm) Si3N4 layer 58 is blanket deposited by PECVD in an AME 5000 equipment onto the structure as illustrated by Fig. 4U.
22. Now, the first metal contact studs of the MO or first level have to be fabricated in two steps using the so-called "resist plug" method. To that end, a 1.1µm thick photoresist layer 59 is deposited onto the structure, then exposed, developed and hardened to UV light at 240°C. The resulting mask is comprised of a pattern of resist plugs generically referenced 59' in Fig. 4V. These plugs will be the nests of the conductive contact studs to be subsequently formed.
23. The present step aims to define the PSG filling matrix. A 1000nm thick PSG layer 60 is deposited onto the structure to fill the space left by the resist plugs 59' with phospho silicate glass (PSG) in an AME 5000 tool at 190°C. A planarizing medium such as a 0.6µm thick photoresist layer 61 is then formed thereupon and baked at 130°C. The resulting structure is shown in Fig. 4W.
24. The structure is etched-back in an AME 5000 tool using a CHF3/He/O2 mixture which etches both materials, i.e. the PSG of layer 60 and the resist of layer 61, at the same etch rate. Once the top of the resist plugs forming mask 59' has been attained (this is monitored by detecting carbon radiation in a standard emission spectroscopy monitoring apparatus), the process is stopped. The remaining resist material forming mask 59' is eliminated by ashing in O2, leaving a PSG matrix generically referenced 60' standing over the structure as illustrated in Fig. 4X. The PSG matrix 60' has a complimentary pattern with respect to the pattern of the resist plug 59', which once eliminated left a corresponding pattern of voids or openings to subsequently receive the contact studs.
25. The wafer is cleaned and the structure is annealed at 760°C during 60mn. Next, the exposed portions of the Si3N4 layer 58 are eliminated by RIE in a TEGAL tool using SF6. Because layer 58 is much thinner than the PSG matrix 60', the latter is just eroded. The structure is annealed again at 600°C during 30mn. The resulting structure with adequate contact stud openings for further processing is shown in Fig. 4Y. Contact stud openings (e.g. 59'A) are still referenced as the corresponding resist plugs.
26. Next, said contact stud openings are filled by successive deposition of a titanium Ti layer and a titanium nitride Ti-N layer that are blanket sputtered on the whole wafer to form a composite Ti-TiN layer referenced 62. Then, said stud openings are filled with a tungsten W layer 63. More details are described in EP-A- 469214 assigned to the present assignee. The deposited metal layers are planarized for instance with the technique described in EP-A-223920 assigned to the present assignee. Planarization of the Ti-TiN and W composite layer produces contact pads 62 and contact studs 63 in stud openings 59' that are referenced with corresponding references. For example, as illustrated in Fig. 4Z, contact pad 62A and contact stud 63A are formed in contact opening 59'A. This step ends the process of forming the first set of half metal contact studs 63A, ...
27. Processing steps 22 to 26 are repeated again to provide the other halves of the metal contact studs. Fig. 5 shows the structure 20 at the end of the M0 level with the first metal contact studs completed. These steps result in the forming of a PSG matrix 64' with contact pads and contact studs generically referenced 65 and 66 respectively embedded therein. Structures of both P and N type bulk FET devices referred to as bNFET at bPFET and pPFET devices are illustrated in Fig. 5. The overpass conductor is referenced 63D. It interconnects an active source/drain region of the bPFET and the gate electrode of a FET (not referenced) corresponding to line 42C. Conductor 63E interconnects an active region of the pFFET and the gate electrode of a FET (not referenced, corresponding to line 42D).

Fig. 6 shows the real lay-out of a 6D-SRAM cell structure obtained according to the present method described in conjunction with Figs. 4A to 4Z, i.e. using four additional masks with respect to a standard CMOS manufacturing process, which allows to implement overpass conductors (e.g. 63D). Cell area is 18.45 µm2.

Fig. 7 shows the real lay-out of similar structure obtained with an alternate version of the present method, with only three additional masks, i.e. without the offering of overpass conductors. There is a slight increase in the cell area, now equal to 21 µm2, which demonstrates the usefulness of the overpass conductors (e.g. 63D) as an efficient feature of the interconnection scheme.

To achieve the final structure (not shown), standard first metallization layer is deposited and patterned to leave metal lands at the M1 mask level. The metallization layer may be a Ti/Al-Cu/Si metallurgy. Metal lands are used for the word lines WL, and busses that are connected to Vcc and Gnd. Normal BEOL process is then conventionally continued until the structure is covered by an insulating film of PECVD oxide.

The steps of depositing the PSG insulating matrix of forming metal contact studs and metal lands could be repeated again should the chip be of the multilevel type (M2, M3, ...). However, note that in the upper levels of the structure, SiO2 is preferred to PSG. A planarization step is to be associated to each stud level. The structure fabrication is terminated by completing the terminal metallurgy steps including forming the contact pads of the Ball Limiting Metallurgy (BLM) and contact terminals (e.g. solder balls) as widely described in the literature.

In order to increase the channel mobility and decrease the threshold voltage VT of the pPFETs, hydrogen passivation of the dangling bonds has to be done. It will help to minimize the effects of the grain boundary potential barriers on device performance. This step, known in the art as the forming gas anneal step, is completed in a furnace at 400°C during 30 mn in a N2/H2 forming gas. This step is performed after the deposition of polysilicon layer 32. It can be repeated several times during the BEOL processing and at any subsequent level, to improve the structure quality.

Thus, in essence, a method of building pseudo-planar thin-film polysilicon gate PFETs (pPFETs) as load devices in a CMOS process is proposed. In the standard planar 6D SRAM cells, the PFETs used as load devices require a lot of area (due to the N-well regions for appropriate isolation) and are fabricated simultaneously with the bulk FET devices. In contradistinction, according to the present invention, the pPFETs are of the thin-film type to increase integration density and are fabricated very early in the CMOS process flow, and in any case, prior to any process step necessary to fabricate the bulk FET devices.

The main advantages of the method of the present invention are summarized hereafter:
I. It allows much more flexibility in the thermal treatment of the body of the pPFETs, because there is no longer any temperature constraints, since no bulk FET device is formed at this stage. This is a great advantage because the recrystallization of the amorphous polysilicon forming said body is a very important step to enlarge its grain size which finally, results in good performance pPFET devices.
II. It is compatible with an N-well process as well as with a P-well process, so that it is compatible with any standard CMOS process.
III. Its process complexity and cost are lowered due to the many common steps that exist between the fabrication of the bulk NFETs and PFET devices on the one hand, and the pPFETs on the other hand:
   - same polysilicon/WSix layer 39 is used for forming the gate electrodes of all FET devices regardless they are bulk FET or pPFET devices
   - same polysilicon gate anneal step
   - same TEOS deposition step for forming the oxide spacers
   - same source/drain implantation steps for both bulk FETs and pPFETs
   - same source/drain activation anneal
   - same silicidation steps.
   With all these common steps, it is clear that the pPFETs can take benefit of all the engineering done for the bulk FET devices, such as the source/drain engineering and the self-alignment technique. Because the steps of forming the pPFETs and bulk FETs are independent, improvements to any of these can be done without impacting the other. This advantage is important because the present process permits to implant the source/drain regions far from the channel regions so that LDD structures can be achieved in the pPFETs. This means that, in spite of dopant diffusion is faster in polysilicon than in silicon, a short channel length is nevertheless achievable in the pPFETs. In addition, self-alignment also helps in precisely defining the channel length of the pPFETs.
IV. It provides a very efficient local interconnect scheme including overpass conductors.
V. When compared to a 6 Device SRAM cell manufactured by a conventional CMOS method, the spacing between the pPFETs and the bulk NFET is much reduced with respect to a standard CMOS process.
VI. It results in pPFETs that are quasi immune to SER (Soft Error Rate). Since the pPFET is formed on top of an isolation region (e.g. 28E), the SER is lowered.
VII. pPFET source/drain regions of all FET devices and gate electrodes thereof are silicided without any extra processing step.

The present invention leads to a structure which is intermediate between a planar device and a completely stacked device, therefore it is a promising solution to satisfy the requirements of a 4Mb Industry Standard SRAM chip because it provides dense and high performance PFETs to be used as load devices. Another obvious applications of the present method can be found in SRAM macros.

Moreover, for logic applications, where an efficient local interconnect scheme is required, the present method also meets such needs.

## Claims

1. A method of forming thin film pseudo-planar polysilicon gate PFETs (pPFETs) simultaneously with bulk PFET and NFET devices in a CMOS or BiCMOS semiconductor structure including the steps of:
a) elaborating a P type silicon substrate (23) having a major surface provided with a plurality of isolation regions (28) as the initial structure;
b) delineating polysilicon lands (32A) above certain isolation regions (28E);
c) forming N-well regions (35) into the substrate (23) where bulk PFETs are to be subsequently formed;
d) forming insulator encapsulated conductive polysilicon studs (39A,B,C,D,E) to be used as gate electrodes of said pPFETs and bulle PFET and NFET devices at desired locations of the structure;
e) forming source/drain regions (50) of the bulk NFETs into the substrate self-aligned to said polysilicon studs ;
f) forming source/drain regions (52) of the bulk PFETs and pPFETs into the substrate and polysilicon lands respectively self-aligned to said polysilicon studs ; and,
g) forming contact regions (53) to the desired locations including said source/drain regions.

2. The method of claim 1 further including the step of:
h) forming an etch stop layer (54) over certain polysilicon studs (39C) and certain regions (22C) of the substrate to facilitate the subsequent formation of overpass conductors on said polysilicon studs.

3. The method of claim 1 or 2 further including the step of:
i) exposing the top of certain polysilicon studs (-39C, 39D);

4. The method of any above claim further including the steps of:
j) blanket depositing an etch stop layer (58) onto the structure;
k) forming an insulating matrix (60') provided with openings onto the structure exposing desired locations of the underlying etch stop layer (58);
l) etching said exposed regions of the etch stop layer;
m) filling the openings of said matrix (60') with a conductive material to form contact studs (63A,DE);

5. The method of any above claims wherein said step b) of delineating a polysilicon lands (321) comprises the steps of:
n) sequentially blanket depositing a thin sacrificial layer (31) and a relatively thick polysilicon layer (32);
o) patterning the said polysilicon layer (32) to form said polysilicon lands(32A);

6. The method of claim 5 further comprising the step of:
p) recrystallizing said polysilicon lands(32A);

7. The method of claim 5 or 6 wherein said step d) of forming said polysilicon studs (39A,B,C,D,E) comprises the steps of:
q) removing the said thin sacrificial layer (31) where exposed and blanket depositing a thin dielectric layer (38);
r) sequentially blanket depositing a relatively thick polysilicon layer, and a WSix layer, to form a composite conductive layer (39); and,
s) blanket depositing a cap insulating layer (40); and,
t) patterning said insulating cap and composite conductive layers (40,39);

8. The method of any above claims further including prior to step e) the steps of:
u) oxidizing the lateral sides of said polysilicon studs (39A,B,C,D,E) to form oxide sidewalls thereon (43);
v) implanting ions to selectively create P-LDD regions (45) in the substrate at the bulk NFET locations;
w) implanting ions to selectively create N-LDD regions (47) in N-well regions (35) at the bulk PFET locations; and,
x) forming etch stop insulator sidewalls (48) on said polysilicon studs;

## Patentansprüche

1. Verfahren zur Herstellung von pseudoplanaren Dünnfilm-PFETs mit Polysilicium-Gate (pPFETs) gleichzeitig mit Volumen-PFET- und -NFET-Bauelementen in einer CMOS- oder BiCMOS-Halbleiterstruktur, das die Schritte umfaßt:
a) Erzeugen eines Substrates (23) aus p-leitendem Silicum mit einer Hauptoberfläche, die mit einer Mehrzahl von Isolationsbereichen (28) versehen ist, als der Ausgangsstruktur;
b) Festlegen von Kontaktflecken (32A) aus Polysilicium über bestimmten Isolationsbereichen (28E);
c) Erzeugen von n-Muldenbereichen (35) in das Substrat (23) hinein, in denen nachfolgend Volumen-PFETs zu bilden sind;
d) Bilden von isolatorverkapselten, leitfähigen Polysiliciumstiften (39A, B, C, D, E), die als Gate-Elektroden der pPFETs und Volumen-PFET- und -NFET-Bauelemente an gewünschten Stellen der Struktur zu verwenden sind;
e) Erzeugen von Source/Drain-Gebieten (50) der Volumen-NFETs in das Substrat hinein, die bezüglich der Polysiliciumstifte selbstjustiert sind;
f) Erzeugen von Source/Drain-Gebieten (52) der Volumen-PFETs und der pPFETs in das Substrat beziehungsweise die Polysilicium-Kontaktflecken hinein, die bezüglich der Polysiliciumstifte selbstjustiert sind; und
g) Bilden von Kontaktbereichen (53) zu den gewünschten Stellen einschließlich der Source/Drain-Gebiete.

2. Verfahren nach Anspruch 1, das des weiteren den Schritt umfaßt:
h) Erzeugen einer Ätzstoppschicht (54) über bestimmten Polysiliciumstiften (39C) und bestimmten Bereichen (22C) des Substrates, um die nachfolgende Bildung von Überbrückungsleitern auf den Polysiliciumstiften zu erleichtern.

3. Verfahren nach Anspruch 1 oder 2, das des weiteren den Schritt umfaßt:
i) Freilegen der Oberseite bestimmter Polysiliciumstifte (39C, 39D).

4. Verfahren nach irgendeinem der obigen Ansprüche, das des weiteren die Schritte umfaßt:
j) deckendes Aufbringen einer Ätzstoppschicht (58) auf die Struktur;
k) Erzeugen einer isolierenden Matrix (60'), die mit Öffnungen auf die Struktur hin versehen ist, welche gewünschte Stellen der darunterliegenden Ätzstoppschicht (58) freilegen;
l) Ätzen der freigelegten Bereiche der Ätzstoppschicht;
m) Füllen der Öffnungen der Matrix (60') mit einem leitfähigen Material, um Kontaktstifte (63A, D, E) zu bilden.

5. Verfahren nach irgendeinem der obigen Ansprüche,wobei der Schritt b) des Festlegens von Polysilicium-Kontaktflecken (32A) die Schritte umfaßt:
n) sequentielles, deckendes Aufbringen einer dünnen Opferschicht (31) und einer relativ dicken Polysiliciumschicht (32);
o) Strukturieren der Polysiliciumschicht (32), um die Polysilicium-Kontaktflecken (32A) zu bilden.

6. Verfahren nach Anspruch 5, das des weiteren den Schritt umfaßt:
p) Rekristallisieren der Polysilicium-Kontaktflecken (32A).

7. Verfahren nach Anspruch 5 oder 6, wobei der Schritt d) der Bildung der Polysiliciumstifte (39A, B, C, D,E) die Schritte umfaßt:
q) Entfernen der dünnen Opferschicht (31) an Stellen, an denen sie freiliegt, und deckendes Aufbringen einer dünnen dielektrischen Schicht (38);
r) sequentielles, deckendes Aufbringen einer relativ dikken Polysiliciumschicht und einer WSiₓ-Schicht, um eine zusammengesetzte leitfähige Schicht (39) zu bilden; und
s) deckendes Aufbringen einer isolierenden Deckschicht (40); und
t) Strukturieren der isolierenden Deckschicht und der zusammengesetzten leitfähigen Schicht (40, 39).

8. Verfahren nach irgendeinem der obigen Ansprüche, das des weiteren vor Schritt e) die Schritte umfaßt:
u) Oxidieren der lateralen Seiten der Polysiliciumstifte (39A, B, C, D, E), um Oxidseitenwände (43) auf denselben zu bilden;
v) Implantieren von Ionen, um selektiv p-LDD-Bereiche (45) in dem Substrat an den Stellen von Volumen-NFETs zu erzeugen;
w) Implantieren von Ionen, um selektiv n-LDD-Bereiche (47) in n-Mulden-Bereichen (35) an den Stellen von Volumen-PFETs zu erzeugen; und
x) Bilden von Ätzstopp-Isolatorseitenwänden (48) auf den Polysiliciumstiften.

## Revendications

1. Procédé consistant à former des PFET à grille de polysilicium pseudoplanar à couche mince (pPFET) simultanément avec des dispositifs PFET et NFET non épitaxiés dans une structure à semiconducteur CMOS ou BiCMOS comprenant les étapes consistant à :
a) élaborer un substrat de silicium de type P (23) comportant une surface principale munie d'une pluralité de régions d'isolement (28) en tant que structure initiale,
b) délimiter des plages de polysilicium (32A) au-dessus de certaines régions d'isolement (28E),
c) former des régions à puits N (35) dans le substrat (23) où les PFET non épitaxiés seront ultérieurement formés,
d) former des ergots de polysilicium conducteurs encapsulés d'isolement (39A, B, C, D, E) destinés à être utilisés comme électrodes de grille desdits pPFET et dispositifs PFET et NFET non épitaxiés à des emplacements souhaités de la structure,
e) former des régions source/drain (50) des NFET non épitaxiés dans le substrat auto-alignées avec lesdits ergots de polysilicium,
f) former des régions source/drain (52) des PFET et pPFET non épitaxiés dans le substrat et les plages de polysilicium, respectivement, auto-alignées avec lesdits ergots de polysilicium, et
g) former des régions de contact (53) aux emplacements souhaités y compris lesdites régions source/drain.

2. Procédé selon la revendication 1 comprenant en outre l'étape consistant à :
h) former une couche d'arrêt de gravure (54) sur certains ergots de polysilicium (39C) et certaines régions du substrat (22C) afin de faciliter la formation ultérieure de conducteurs de passage supérieurs sur lesdits ergots de polysilicium.

3. Procédé selon la revendication 1 ou la revendication 2 comprenant en outre l'étape consistant à :
i) exposer le dessus de certains ergots de polysilicium (39C, 39D).

4. Procédé selon l'une quelconque des revendications précédentes comprenant en outre les étapes consistant à :
j) déposer une couche d'arrêt de gravure en couverture (58) sur la structure,
k) former une matrice isolante (60') munie d'ouvertures sur la structure exposant les emplacements souhaités de la couche d'arrêt de gravure sous-jacente (58),
l) graver lesdites régions exposées de la couche d'arrêt de gravure,
m) remplir les ouvertures de ladite matrice (60') d'un matériau conducteur afin de former des ergots de contact (63A, D, E).

5. Procédé selon l'une quelconque des revendications précédentes dans lequel ladite étape b) consistant à délimiter des plages de polysilicium (32A), comprend les étapes consistant à :
n) déposer séquentiellement en couverture une couche mince
sacrifiée (31) et une couche de polysilicium relativement épaisse (32),
o) mettre en motif ladite couche de polysilicium (32) afin de former lesdites plages de polysilicium (32A).

6. Procédé selon la revendication 5 comprenant en outre l'étape consistant à :
p) recristalliser lesdites plages de polysilicium (32A).

7. Procédé selon la revendication 5 ou la revendication 6 dans lequel ladite étape d) consistant à former lesdits ergots de polysilicium (39A, B, C, D, E) comprend les étapes consistant à :
q) éliminer ladite couche sacrifiée mince (31) là où elle a été exposée et déposer en couverture une fine couche diélectrique (38),
r) déposer séquentiellement en couverture une couche de polysilicium relativement épaisse, et une couche en WSix, afin de former une couche conductrice composite (39), et
s) déposer en couverture une couche isolante de coiffe (40), et
t) mettre en motif lesdites coiffe isolante et couche conductrice composite (40, 39).

8. Procédé selon l'une quelconque des revendications précédentes comprenant en outre, avant l'étape e), les étapes consistant à :
u) oxyder les parois latérales desdits ergots de polysilicium (39A, B, C, D, E), afin de former des parois latérales d'oxyde sur ceux-ci (43),
v) réaliser une implantation ionique afin de créer sélectivement des régions P-LDD (45) dans le substrat aux emplacements des NFET non épitaxiés,
w) réaliser une implantation ionique afin de créer sélectivement des régions N-LDD (47) dans les régions à puits N (35) aux emplacements des PFET non épitaxiés, et
x) former des parois latérales d'isolement d'arrêt de gravure (48) sur lesdits ergots de polysilicium.
